# EUROPEAN PATENT SPECIFICATION

(11) **EP 4 427 261 B1**
(45) Date of publication and mention of the grant of the patent: **26.11.2025**
(21) Application number: 23721023.2
(22) Date of filing: 03.03.2023
(51) Int. Cl.: H01L 21/36

(54) **METHOD OF SELECTIVE GROWTH OF VAN DER WAALS HETEROSTRUCTURES ON A GRAPHENE SUBSTRATE BY CHEMICAL VAPOR DEPOSITION USING ELECTRON-BEAM IRRADIATION**
VERFAHREN ZUM SELEKTIVEN WACHSTUM VON VAN-DER-WAALS-HETEROSTRUKTUREN AUF EINEM GRAPHENSUBSTRAT DURCH CHEMISCHE DAMPFABSCHEIDUNG MIT ELEKTRONENBESTRAHLUNG
PROCÉDÉ DE CROISSANCE SÉLECTIVE D'HÉTÉROSTRUCTURES DE VAN DER WAALS SUR UN SUBSTRAT DE GRAPHÈNE PAR DÉPÔT CHIMIQUE EN PHASE VAPEUR À L'AIDE D'UNE EXPOSITION À UN FAISCEAU D'ÉLECTRONS

(30) Priority: 14.09.2022 PL 44227522
(43) Date of publication of application: 11.09.2024
(73) Proprietor: POLITECHNIKA WARSZAWSKA, 00-661 Warszawa (PL)
(72) Inventor: SITEK, Jakub, 02-796 Warszawa (PL); CZERNIAK- OSIEWICZ, Karolina, 01-248 Warszawa (PL)
(74) Representative: JWP Patent & Trademark Attorneys
(86) International application number: PCT/PL2023/050013
(87) International publication number: WO 2024/058678

(56) References cited:
- WO-A1-2013/140181
- CN-A- 107 634 089
- US-A1- 2016 379 822

## Description

The object of the invention is a method of growing van der Waals heterostructures based on transition metal sulfides on graphene while maintaining selectivity control of the growth area by using electron-beam irradiation, and a heterostructure manufactured by this method.

Van der Waals heterostructures are stacked layers of layered materials, i.e. these in which ionic and covalent bonds are located only in a plane of atomic layers. A characteristic feature of the van der Waals heterostructures is the fact that individual layers of a stack forming the heterostructure are interconnected by weak interatomic interactions (the van der Waals interactions). The van der Waals heterostructures most often take the form of stacks of two-dimensional (2D) materials, i.e. these that have the thickness of single atomic or molecular layers.

An example of a two-dimensional material is graphene, a single layer which consists of a hexagonal network of carbon atoms. Graphene is characterized by a unit cell consisting of two atoms, each with four valence electrons. One of these valence electrons, due to its position in the atomic orbital perpendicular to the graphene plane, can form weak van der Waals bonds, due to which single graphene layers arranged one on top of the other in large numbers make up the bulk material, which is graphite. If, instead of another layer of carbon atoms, another two-dimensional material is laid on graphene, this bonding will create a van der Waals heterostructure.

Another known type of two-dimensional materials are transition metal dichalcogenides (TMD), which consist of atoms from the D block of the periodic table of elements attached to a chalcogen (an element from the group 16 of the periodic table), according to the formula MX₂, where M - a transition metal (e.g. Mo, W, Pt), X - a chalcogen (e.g. S, Se, Te). One of the most frequently studied single layers of transition metal dichalcogenides are molybdenum disulfide (MoS₂) and tungsten disulfide (WS₂).

All the above-mentioned materials (graphene, MoS₂, WS₂) in a form of a single atomic layer are characterized by very interesting properties when it comes to their use in nanoelectronics. Graphene is a semi-metal that perfectly conducts electricity, thanks to which it constitutes an excellent material for the manufacture of electrodes in electronic devices. MoS₂ and WS₂, in turn, most often occur in the 2H polytype, in which these materials are semiconductors with a direct band gap (in the case of a monolayer). The direct band gap semiconductors are ideal for use in devices such as transistors, and the energy of the band gap in case of these two materials corresponds to the energy from the range of visible light, thanks to what they can generate electrical carriers under illumination (for applications e.g. in photodetection).

The combination of two two-dimensional materials (for example, graphene with MoS₂) and creating a van der Waals heterostructure thereby gives a number of important applications in modern electronics. By using these materials in a heterostructure, photosensitive field-effect transistors with advantageously designed electrical contacts (the graphene-MoS₂ contact) can be obtained. Such devices can also be used as photodetectors and optical storage, storing information about the illumination of the sample for a longer period (from seconds to months). The challenge, however, constitutes the manufature of van der Waals heterostructures and the fabrication of devices based on these materials.

Heterostructures are most often manufactured by two main methods. One of them is mechanical exfoliation (delamination), which consists in separating weakly bound layers from bulk crystals and placing these layers in an appropriate method on a chosen substrate. Due to the small size, randomness of the delamination process and difficulties in the precise arrangement of layers on one another on the substrate, this method is inefficient and practically impossible to adapt to the industrial scale. The second method of achieving heterostructures is layer-by-layer growth using the chemical vapor deposition (CVD) method. In this method, at appropriately high temperatures (not lower than 400 °C) and under appropriate pressure (not higher than 1000 hPa), precursors (substances involved in a chemical reaction that results in the formation of desired chemical compounds) are delivered to the substrate in a gaseous form and then react with each other or undergo thermolysis, and the converted compounds are deposited on the loaded substrate in the form of the desired material, most often in the form of thin-layer crystals. The growth by the CVD method provides a very wide range of coverage (0-100%) of the chosen substrate with a layer of a two-dimensional material, if optimal process parameters are assorted.

CVD is a scalable and repeatable method, but the process itself highly depends on the selection and preparation of a substrate. Moreover, this method does not allow to obtain the growth selectivity of the chosen material on a specified area of the substrate. In the case of the CVD method, manufacture of an electronic device requires additional steps, such as plasma etching, to limit the area of the material on the substrate solely to the designed channel of the device, which requires the use of special equipment and increases fabrication costs. Therefore, the development of modern electronics could greatly benefit from the CVD method that would provide a well-optimized, preferably selective, growth of van der Waals heterostructures, so that the process is scalable as well as requiring a minimum of additional steps.

The patent description CN111146079A and the publication "General synthesis of two-dimensional van der Waals heterostructure arrays" (Li et al., Nature 579, 368-374 (2020)) present growth of vertical van der Waals heterostructures (i.e. those in which individual layers are stacked on top of each other) consisting of materials with metallic and semiconducting properties. This method uses laser irradiation of assigned areas that etch defects in the semiconductor layer (e.g. MoS₂, WS₂). On such a defective substrate, the CVD process is then carried out, which allows obtaining vertical TMD/TMD heterostructures, e.g. VSe₂/WSe₂ or CoTe₂/WSe₂. In this method, it is necessary to manufacture a multilayer substrate material and it cannot be used for monolayer materials.

The patent description US10465276B2 presents the growth process of two-dimensional materials and their vertical heterostructures (TMD/graphene), the selectivity of which is reached by using a lithographic resist and masking of the appropriate areas of the sample. This process makes it possible to perform masking several times in order to obtain a *p-n* junction. This is a resist-based process that may leave behind chemical contamination due to spreading the resist on the surface of the substrate and removing it.

The patent description US10872973B2 presents the growth process of antimonene, i.e. an allotrope of a single layer of antimony atoms, on a previously etched substrate with a monolayer of a two-dimensional material, e.g. WS₂ or MoS₂, thus creating a vertical van der Waals heterostructure. The growth selectivity is based on energetically favorable nucleation of antimonene on the 2D material, but not on the surrounding substrate, e.g. sapphire or silicon. However, the method is adapted only to the formation of the antimonene layer, which additionally needs to be adapted to the assigned properties, e.g. by thinning with plasma etching to obtain the semiconducting properties of the material.

The patent description US2017025505A1 and the publication "Patterned arrays of lateral heterojunctions within monolayer two-dimensional semiconductors" (Mahjouri-Samani et al., Nature Communications 6, 7749 (2015)) present the process of selective growth of lateral heterostructures (i.e. those that are in contact with the edges of layers), by sulfurizing lithographically unmasked areas. This description presents a process where a monolayer of a starting material (e.g., MoSe₂) is prepared in a lithographic process by masking assigned areas, which are then sulfurized to form a sulfur-based material (MoS₂), resulting in a lateral heterostructure.

The patent description WO2018005838A1 and the publication "Large-scale chemical assembly of atomically thin transistors and circuits" (Zhao et al., Nature Nanotechnology 11, 954-959 (2016)) present a method for growing a lateral heterostructure based on graphene. In this method, the graphene is plasma etched, and then the etched area is subjected to the process of nucleation of the MoS₂ layer. On the sample prepared by this method, a MoS₂ monolayer grows and a graphene-MoS₂ heterojunction is formed. It is the method for the manufacture of lateral structures using lithography, and plasma etching that contaminates the surface. The method itself indicates process residues as a nucleation site for the next layer of material.

The patent description CN113327840A and the publication "Grain-Boundary Engineering of Monolayer MoS2 for Energy-Efficient Lateral Synaptic Devices" (Wang et al., Advanced Materials 33(32), 219243 (2021)) present a method for the growth of lateral heterostructures by oxidation of the base material layer (e.g. MoS₂, WS₂) with a laser beam to manufacture the appropriate transition metal oxides (MoOₓ, WOₓ). This oxide is then reduced with another chalcogen, e.g. selenium. In this way, it is possible to achieve heterostructures such as MoS₂-MoSe₂ or WS₂-WSe₂ on a substrate prepared with a laser beam. The limitations of this method result from the oxidation process - possible configurations of heterostructures are limited to the same transition metal due to the fact that the method is based on oxidation of the base layer.

The publication "Endoepitaxial growth of monolayer mosaic heterostructures" (Zhang et al., Nature Nanotechnology 17, 493-499 (2022)) presents the selective growth of lateral heterostructures by laser and thermal etching. In this method, a laser was used to introduce point defects into a continuous TMD monolayer, which were then enlarged by thermal etching. On such a defective material, the process of growth of other TMDs was then carried out, thus obtaining lateral heterostructures.

The selectivity in most of the above-mentioned methods is realized through lithographic methods, which can lead to contamination of the base layers and doping, resulting from the need to cover the layers with polymeric materials. In the case of laser methods, the layer is most frequently removed or heavily degraded, which is not advisable when it is necessary to maintain the physical and electrical properties of the base layer. The indicated methods show great diversity, but none of them represent a selective method in which an electron beam is used to control the area of selective growth. The invention relates to a process for selective growth of van der Waals heterostructures of transition metal dichalcogenide on graphene by means of the chemical vapor deposition. The selectivity of the process is ensured by irradiating the sample with a very strong electron beam, but without the use of a resist and other chemical reagents commonly used in a lithographic process. It turns out that if a sample of graphene synthesized by chemical vapor deposition on an assigned substrate or transferred onto another substrate is subjected to a very intense electron beam, the irradiated area undergoes the process of introducing structural defects that do not cause complete degradation of the layer. It should be noted here that the substrate irradiated in this way is indistinguishable from the non-irradiated area when viewed by optical microscopy, what matters in optoelectronic applications. Distinguishing between irradiated and non-irradiated areas can only be done by using a scanning electron microscope in *in-lens* imaging mode, allowing to distinguish areas with a different work function, or using Raman spectroscopy, which allows measuring the intensity of the D peak, being a measure of graphene defects.

The sample prepared in this way is subjected to the growth process by chemical vapor deposition in order to manufacture a second monolayer, which together with the graphene substrate will form a heterostructure. Depending on the method of storing the sample after irradiation with an electron beam, positive growth (only in the place irradiated with the beam, a monolayer of transition metal dichalcogenides grows) or negative growth (only in the place irradiated with an electron beam, we observe lack of synthesized crystals of transition metal dichalcogenides - these crystals grow in the area surrounding the irradiated place) can be obtained. The present method and the heterostructure manufactured by the method was developed as a result of work in the Graphene Flagship project (project number Graphene Flagship Core3 N° 881603), funded by the European Commission under the Horizon 2020 programme.

The invention relates to a method for manufacture of van der Waals heterostructures based on transition metal dichalcogenides selectively grown by chemical vapor deposition on a graphene substrate, in which the surface of the graphene substrate was irradiated with an electron beam, whereupon the growth of transition metal dichalcogenides in the area irradiated with the electron beam was controlled by exposure of the irradiated substrate to the air.

Preferably, the minimum dose of the electron beam is 1,000 µC/cm².

Preferably, the maximum dose of the electron beam is 1,000,000 µC/cm². The higher the dose, the greater the difference in the synthesis of transition metal dichalcogenides between the irradiated and non-irradiated areas.

The method of selective growth of two-dimensional transition metal dichalcogenides on a graphene substrate is characterized by high precision in defining the desired shape of the target electronic device (irradiation is handled with 100-nm precision) and allows the manufacture of both very small heterostructures with a strictly defined shape (not smaller than 0.2x0.2 µm²), as well as large-area structures (limited only by the size of the electron lithography chamber, usually several dozen cm²).

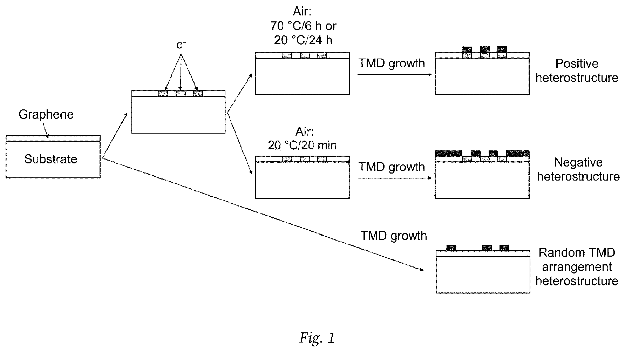

The invention in embodiment is shown in the drawing, wherein
Fig. 1 is a diagram illustrating the growth of a negative heterostructure, positive heterostructure, and heterostructure with random distribution of transition metal dichalcogenide (TMD) crystals.

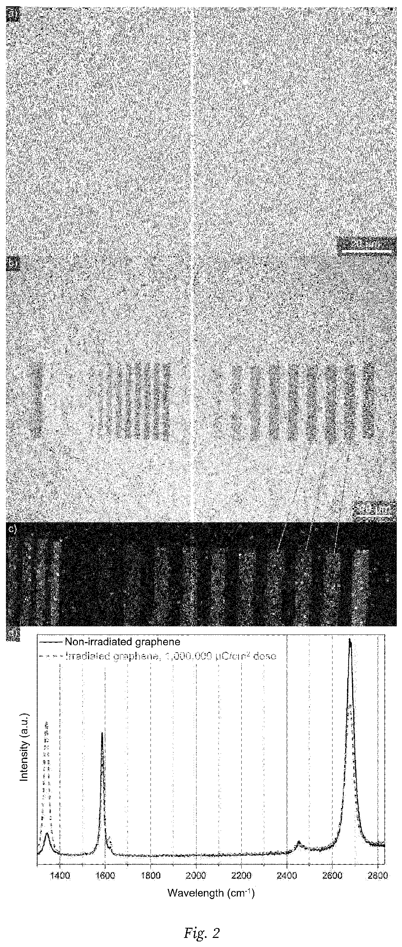

Fig. 2 shows graphene irradiated with an electron beam: a) image from an optical microscope; b) an *in-lens* contrast scanning electron microscope image; c) spatial mapping of the defect peak intensity (D) of graphene by Raman spectroscopy (the brighter the area, the greater graphene defects); d) the defect level of graphene irradiated with the maximum dose of electrons (a dashed line) compared to non-irradiated graphene (a continuous line).

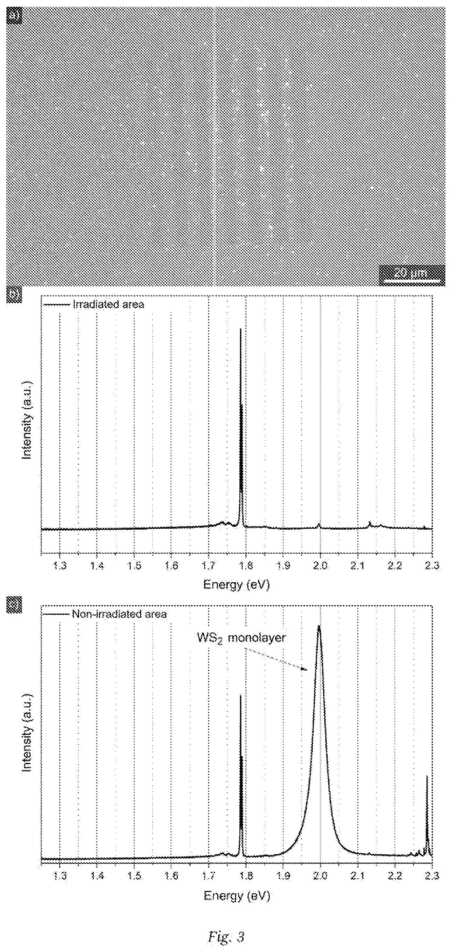

Fig. 3 shows: a) an optical microscope photograph showing the growth of a negative heterostructure; b) a photoluminescence spectrum from the irradiated area of the negative heterostructure; c) a photoluminescence spectrum from the non-irradiated area of the negative heterostructure.

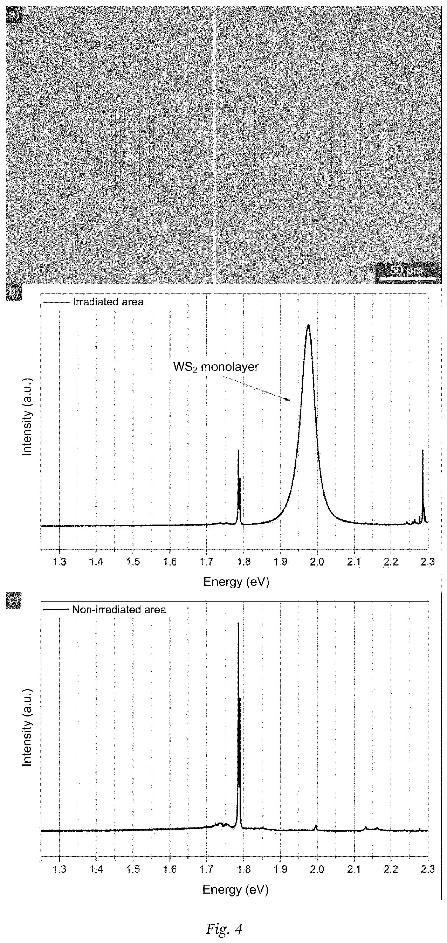

Fig. 4 shows: a) an optical microscope photo showing the growth of positive heterostructure; b) a photoluminescence spectrum from the irradiated area of the positive heterostructure; c) a photoluminescence spectrum from the non-irradiated area of the positive heterostructure.

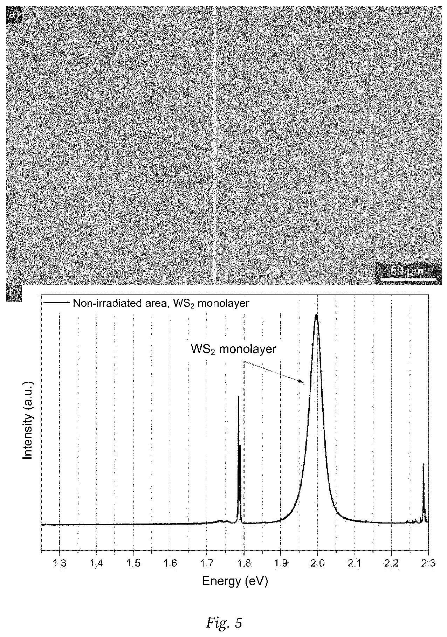

Fig. 5 shows: a) an optical microscope photograph showing the lack of growth selectivity in the absence of electron-beam irradiation; b) a photoluminescence spectrum of a transition metal dichalcogenide crystal in the area non-irradiated with an electron beam.

The method according to the invention is further illustrated in the following examples, and the efficiency of the selective growth method was specified from the results, details of which are shown in the figures.

### Example 1, showing growth of a negative heterostructure.

A sample of previously synthesized monolayer graphene on a sapphire substrate using the CVD method is placed in the electron lithography chamber. The sample does not require any additional preparation before the irradiation process. In the electron lithography, the area of irradiation of the substrate (graphene) with an electron beam is specified. The beam parameters are set to 100,000 µC/cm², and the irradiation step to 0.2 µm - this is the distance between successive points of irradiation with an electron beam in the x and y axis of the substrate plane. Irradiation is performed using an aperture of 120 µm. The dose of 100,000 µC/cm² allows to obtain a clean area on the sample, without additional impurities resulting from excessive attachment of particles at defects.

After irradiation of the graphene, the sample is taken out from the chamber and, without undue delay, placed in the process chamber of the furnace to carry out the process of synthesizing a transition metal dichalcogenide on the top. The total residence time of the sample in the air between taking from the lithography chamber out and inserting into the furnace process chamber is 10 minutes. For the negative growth, samples must not be subjected to air for more than 20 minutes after the irradiation. Their contact with the air should be limited only to the moment of transferring them from the electron lithography chamber to the furnace in order to perform the CVD growth process.

The process of growth of transition metal dichalcogenide monolayers (e.g. MoS₂ or WS₂) is carried out in the furnace. The growth process takes place at 900°C with the use of sublimed sulfur, tungsten oxide and sodium chloride as precursors in the argon atmosphere at the pressure of 20 mbar. As an effect result of the CVD process, the WS₂ crystals cover the entire substrate except for the area determined by irradiation with the electron beam. After taking out the sample from the furnace, the process is completed and the van der Waals heterostructure is prepared, in which the bottom layer is graphene, while the WS₂ layer is synthesized on it in the place where the electron beam was not used. Places illuminated by an electron beam are clean and covered with a graphene monolayer only.

### Example 2, showing growth of a positive heterostructure.

A sample of previously synthesized monolayer graphene on a sapphire substrate using the CVD method is placed in the electron lithography chamber. The sample does not require any additional preparation before the irradiation process. In the electron lithography, the area of irradiation of the substrate (graphene) with an electron beam is specified. The beam parameters are set to 100,000 µC/cm², and the irradiation step to 0.2 µm - this is the distance between successive points of irradiation with an electron beam in the x and y axis of the substrate plane. Irradiation is performed using an aperture of 120 µm. The dose of 100,000 µC/cm² allows to achieve a clean area on the sample, without additional impurities resulting from excessive attachment of particles at defects.

After irradiation of graphene, the sample is taken out from the chamber and left for 65 h on a heating table having a temperature of 70°C in the air. Then the sample is loaded into the process chamber of the furnace and the process of growth of transition metal dichalcogenide monolayers (e.g. MoS₂ or WS₂) is carried out. The growth process takes place at 900°C with the use of sublimed sulfur, tungsten oxide and sodium chloride as precursors in the argon atmosphere at the pressure of 20 mbar, with the amounts of precursors being less than in Example 1. As an effect of the CVD process, the WS₂ crystals cover the area determined by irradiation with the electron beam to a much greater extent (over 30%) and in larger sizes (over 3 µm) than in the non-irradiated area (5% and 0.5 µm, respectively). After taking out the sample from the furnace, the process is completed and the van der Waals heterostructure is prepared, in which the bottom layer is graphene, while the WS₂ layer is synthesized on it in the place where the electron beam has illuminated the surface of the sample.

### Example 3, showing the growth of a heterostructure without controlling growth selectivity of transition metal dichalcogenides

A sample of previously synthesized monolayer graphene on a sapphire substrate using the CVD method is placed in the process chamber of the furnace to carry out the process of synthesizing the transition metal dichalcogenide on top, while the residence time of graphene in the air is irrelevant. The process of growth of the transition metal dichalcogenide monolayers (e.g. MoS₂, WS₂) is carried out in the furnace. The growth process takes place at 900°C with the use of sublimed sulfur, tungsten oxide and sodium chloride as precursors in the argon atmosphere at the pressure of 20 mbar. As a result, dichalcogenide crystals cover random areas of the substrate. After taking out the sample from the furnace, the process is completed and the van der Waals heterostructure is prepared in which the bottom layer is graphene, and on it WS₂ is synthesized at random areas of graphene. In this process, due to the lack of irradiation of the substrate with an electron beam, it is impossible to control the growth area of transition metal dichalcogenides, and they grow at random places.

## Claims

1. A method for the manufacture of van der Waals heterostructures based on transition metal dichalcogenides selectively grown by the chemical vapor deposition on a graphene substrate, **characterized in that**
the surface of the graphene substrate was irradiated with an electron beam, whereupon the growth of transition metal dichalcogenides in the area irradiated with an electron beam was controlled by exposing the irradiated substrate to the air.

2. The method according to claim 1, **characterized in that** a minimum dose of the electron beam is 1,000 µC/cm².

3. The method according to claim 1 or 2, **characterized in that** a maximum dose of the electron beam is 1,000,000 µC/cm².

4. The method according to any one of claims from 1 to 3, **characterized in that** for the growth with increased nucleation in the irradiated portions, the exposure time of the irradiated substrate to the air is at least 24 hours at a temperature of 20°C to obtain growth of transition metal dichalcogenides in the area irradiated with the electron beam.

5. The method according to any one of claims from 1 to 3, **characterized in that** for the growth with increased nucleation in the irradiated portions, the exposure time of the irradiated substrate to the air is at least 6 hours with simultaneous placing of the irradiated graphene on a heating plate in a temperature of at least 70°C.

6. The method according to any one of claims from 1 to 5, **characterized in that** for the growth with blocked nucleation in the irradiated areas, the exposure time of the irradiated substrate to the air is at most 20 minutes, in order not to obtain the growth of transition metal dichalcogenides in the area irradiated with an electron beam.

7. The method according to any one of claims from 1 to 6, **characterized in that** the graphene substrate layer is degraded after the irradiation process what is measured by Raman spectroscopy using a 532 nm green laser and specified as: the amplitude of the graphene D peak in the irradiated portions is higher than the amplitude of the graphene D peak in the unirradiated portions; and the graphene D peak amplitude in the irradiated portions is not greater than the graphene 2D peak amplitude in the irradiated portions.

## Patentansprüche

1. Das Verfahren zur Herstellung von Van-Der-Waals-Heterostrukturen basierend auf einem Übergang von Metalldichalkogeniden, selektiv gezüchtet durch chemische Gasphasenabscheidung auf einem Graphen-Substrat,
**dadurch gekennzeichnet, dass**
die Oberfläche des Graphen-Substrats mit einem Elektronenstrahl bestrahlt wurde, woraufhin das Wachstum von Übergangsmetalldichalkogeniden in dem mit einem Elektronenstrahl bestrahlten Bereich kontrolliert wurde, indem das bestrahlte Substrat der Luft ausgesetzt wurde.

2. Das Verfahren nach Anspruch 1, **dadurch gekennzeichnet, dass** eine minimale Dosis des Elektrons 1.000 µC/cm₂ beträgt.

3. Das Verfahren nach Anspruch 1 oder 2, **dadurch gekennzeichnet, dass** eine maximale Dosis des Elektronenstrahls 1.000.000 µC/cm₂ beträgt.

4. Das Verfahren nach einem der Ansprüche 1 bis 3, **dadurch gekennzeichnet, dass** für das Wachstum mit erhöhter Keimbildung in den bestrahlten Abschnitten die Expositionszeit des bestrahlten Substrats an der Luft mindestens 24 Stunden bei einer Temperatur von 20°C beträgt, um Wachstum des Übergangs von Metalldichalkogeniden in dem mit dem Elektronenstrahl bestrahlten Bereich zu erhalten.

5. Das Verfahren nach einem der Ansprüche 1 bis 3, **dadurch gekennzeichnet, dass** für das Wachstum mit erhöhter Keimbildung in den bestrahlten Abschnitten die Expositionszeit des bestrahlten Substrats gegenüber der Luft mindestens 6 Stunden beträgt, bei gleichzeitiger Platzierung des bestrahlten Graphens auf einer Heizplatte bei einer Temperatur von mindestens 70°C.

6. Das Verfahren nach einem der Ansprüche 1 bis 5, **dadurch gekennzeichnet, dass** für das Wachstum mit blockierter Keimbildung in den bestrahlten Bereichen die Einwirkzeit des bestrahlten Substrats an der Luft höchstens 20 Minuten beträgt, um das Wachstum des Übergangs von Metalldichalkogeniden in dem mit einem Elektronenstrahl bestrahlten Bereich nicht zu erhalten.

7. Das Verfahren nach einem der Ansprüche 1 bis 6, **dadurch gekennzeichnet, dass** die Graphensubstratschicht nach dem Bestrahlungsprozess abgebaut wird, was durch Raman-Spektroskopie unter Verwendung eines 532 nm grünen Lasers gemessen wird und spezifiziert ist als: die Amplitude des Graphen-D-Peaks in den bestrahlten Abschnitten ist höher als die Amplitude des Graphen-D-Peaks in den unbestrahlten Abschnitten; und die Amplitude des Graphen-Peaks in den bestrahlten Abschnitten ist nicht größer als die Amplitude des Graphen-2D-Peaks in den bestrahlten Abschnitten.

## Revendications

1. Procédé de fabrication des hétérostructures de van der Waals basées sur croisées de manière sélective par dépôt chimique en phase vapeur sur un substrat de graphène, **caractérisé en ce que** la surface du substrat de graphène a été irradiée par faisceau électronique après quoi la croissance des dichalcogénures de métaux de transition dans la région irradiée par faisceau électronique était contrôlée en exposant le substrat irradié à l'air.

2. Procédé de fabrication selon la revendication 1, **caractérisé en ce qu'**une dose minimum, du faisceau électronique est 1.000 µC/cm².

3. Procédé de fabrication selon la revendication 1 ou 2, **caractérisé en ce qu'**une dose maximum, du faisceau électronique est 1.000.000 µC/cm².

4. Procédé de fabrication selon l'une quelconque des revendications 1 à 3, **caractérisé en ce que** quant à germination augmentée dans des parties irradiées, le temps d'exposition du substrat irradié à l'aire est au moins 24 heures à une température de 20°C pour obtenir la croissance des dichalcogénures de métaux de transition dans la région irradiée par faisceau électronique.

5. Procédé de fabrication selon l'une quelconque des revendications 1 à 3, **caractérisé en ce que** quant à germination augmentée dans des parties irradiées, le temps d'exposition du substrat irradié à l'aire est au moins 6 heures avec la mise en place simultanée du graphène irradié sur un plateau chauffante à une température d'au moins 70°C.

6. Procédé de fabrication selon l'une quelconque des revendications 1 à 5, **caractérisé en ce que** quant à germination empêchée dans des parties irradiées, le temps d'exposition du substrat irradié à l'aire est au maximum 20 minutes, afin de ne pas obtenir la croissance des dichalcogénures de métaux de transition dans la région irradiée par faisceau électronique.

7. Procédé de fabrication selon l'une quelconque des revendications 1 à 6, **caractérisé en ce que** la couche du substrat de graphène est dégradée après le processus d'irradiation qui est mesurée par spectroscopie Raman en utilisant un laser vert de 532 nm et indiquée en tant que : l'amplitude de crête D du graphène dans des parties irradiées est supérieure à l'amplitude de crête D du graphène dans des parties non irradiées ; et l'amplitude de crête du graphène dans des parties irradiées n'est pas supérieure à l'amplitude de crête du graphène bidimensionnel dans des parties irradiées.
